Europäisches Patentamt

European Patent Office

Office européen des brevets

(11) Veröffentlichungsnummer: **0 315 760**
**A1**

(12) **EUROPÄISCHE PATENTANMELDUNG**

(21) Anmeldenummer: **88115275.5**

(22) Anmeldetag: **17.09.88**

(51) Int. Cl.⁴: **H05K 7/14**

(30) Priorität: **07.11.87 CH 4347/87**

(43) Veröffentlichungstag der Anmeldung:
**17.05.89 Patentblatt 89/20**

(84) Benannte Vertragsstaaten:
**CH DE FR GB IT LI NL SE**

(71) Anmelder: **CONTRAVES AG**
**Schaffhauserstrasse 580**
**CH-8052 Zürich(CH)**

(72) Erfinder: **Kuster, Manfred**
**Rietgrabenstrasse 7**
**CH-8152 Opfikon(CH)**

(54) **Führungsanordnung für Fronteinschübe von Apparate-, insbesondere Elektronikschränken.**

(57) Am Apparateschrank (1) ist vor der Frontöffnung (2) eine Horizontalführung (10) lösbar als Hilfsvorrichtung angebracht, um einen einzubauenden oder ausgebauten Fronteinschub (5′) vorübergehend aufzunehmen. Die Horizontalführung (10) ist auf die Einbauhöhe des Einschubes ausgerichtet, wozu Mittel zur Höhenpositionierung, z.B. Montagebohrungen (4) an den Seitenpfosten (3) des Schrankes (1) vorhanden sind. An der Horizontalführung (10) sind zweckmässigerweise Fixiermittel vorhanden, um den Fronteinschub (5′) in ausgebauter Lage festzulegen und ferner Seitenführungen zur Lenkung der Gleitbewegungen beim Ein- und Ausbau des Einschubes. Die preisgünstige, wegnehmbare Hilfsvorrichtung ermöglicht den mühelosen Einbau wie auch Wartungsarbeiten an Fronteinschüben, auch bei mobilen Anlagen, z.B. auf schwankenden Schiffen.

FIG. 1

EP 0 315 760 A1

## Führungsanordnung für Fronteinschübe von Apparate-, inbesondere Elektronikschränken

Die Erfindung betrifft eine Führungsanordnung für Fronteinschübe von Apparate-, insbesondere Elektronikschränken.

Elektronikschränke wie auch andere Apparateschränke (z.B. für physikalische Mess- und Steueranlagen, Pneumatik- und Hydraulikanlagen usw.) werden häufig mit mehreren Baugruppen in Form von Fronteinschüben ausgeführt, die einzeln durch die Frontöffnung des Schrankes ein- und ausbaubar sind. Hierbei besteht aus Gründen möglichst geringer Abmessungen normalerweise für die Baugruppen oder "Chassis" nur ein geringes Spiel in der Breite wie in der Höhe. Das genaue Ausrichten und "Zielen" beim Einbau der oft schweren Fronteinschübe ist deshalb schwierig, und vor allem bei mobilen Anlagen auf Fahrzeugen und Schiffen besteht die Gefahr von Beschädigungen. Ferner müssen bei ausgebautem, vor der Frontöffnung des Schranks befindlichem Einschub zumeist noch Steckverbindungen an der Rückseite des Einschubes hergestellt oder gelöst werden. Solche Manipulationen lassen sich von einer Person allein nicht ausführen. Deshalb wurden Fronteinschübe bisher schubladenartig auf im Apparateschrank eingebauten Rollenauszügen montiert. Diese Lösung ist allerdings teuer, erhöht das Gewicht und erfordert zusätzlichen Platz in der Breite; der Aufwand (für jeden einzelnen Einschub) lässt sich auch deshalb kaum rechtfertigen, weil die Einschübe im allgemeinen nicht häufig ein- und ausgebaut werden. Auch kann selbst das Einsetzen eines Einschubes in einen Rollenauszug Schwierigkeiten bereiten, jedenfalls z.B. auf einem schwankenden Schiff.

Mit der Erfindung wird deshalb eine Führungsanordnung für Fronteinschübe angestrebt, welche bei geringem Aufwand den leichten und sicheren Ein- und Ausbau wie auch Manipulationen an den Einschüben vor der Frontöffnung des Apparateschrankes ermöglicht.

Diese Aufgabe wird erfindungsgemäss gelöst durch eine vor der Frontöffnung des Schrankes lösbar anbringbare Horizontalführung, die auf die Einbauhöhe eines Fronteinschubes ausgerichtet und zu dessen vorübergehenden Aufnahme ausserhalb des Schrankes ausgebildet ist. Mit einer solchen wegnehmbaren Hilfseinrichtung erübrigen sich kostspielige und wenig benützte, permanente Einbauten im Apparateschrank, sie lässt bei optimaler Raumausnützung geringere Schrankabmessungen zu und ermöglicht die sichere Einmann-Bedienung der Fronteinschübe.

Zweckmässige weitere Ausgestaltungen sind in den Patentansprüchen 2 bis 5 angegeben.

Ein Ausführungsbeispiel der Erfindung wird nachstehend im Zusammenhang mit der Zeichnung näher erläutert.

Fig. 1 ist die perspektivische Ansicht eines Apparateschrankes mit einem eingebauten und einem von einer vorgebauten Horizontalführung aufgenommenen Fronteinschub,

Fig. 2 zeigt in etwas grösserem Masstab die rechte Hälfte (in Fig. 1 gesehen) der vertikal geschnittenen Horizontalführung mit einem Teil des sie tragenden Seitenpfostens des Apparateschrankes, und

Fig. 3 ist eine Draufsicht (bei geschnittenem Seitenpfosten) auf die Anordnung nach Fig. 2.

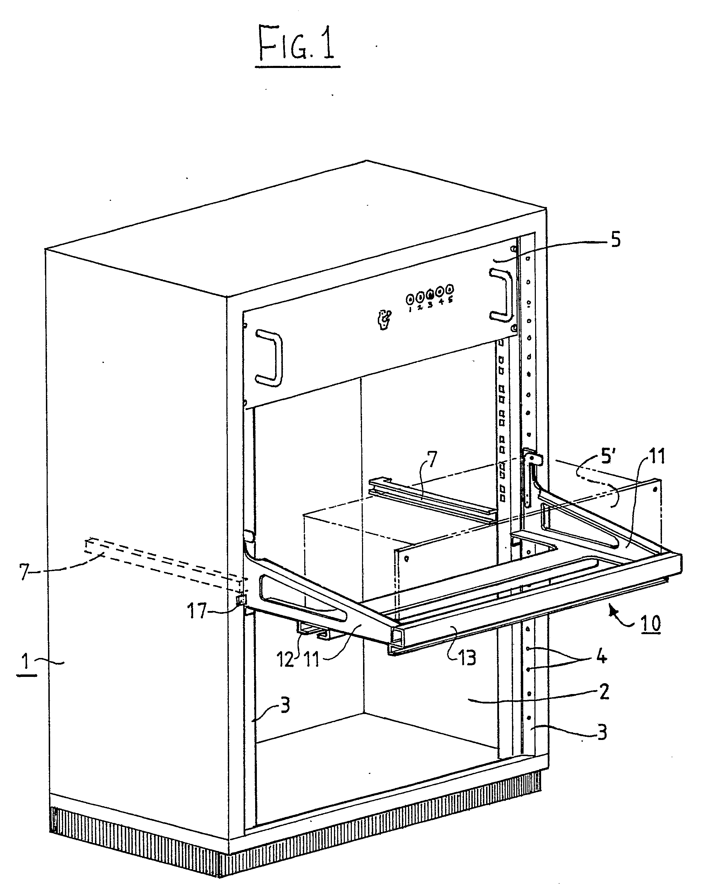

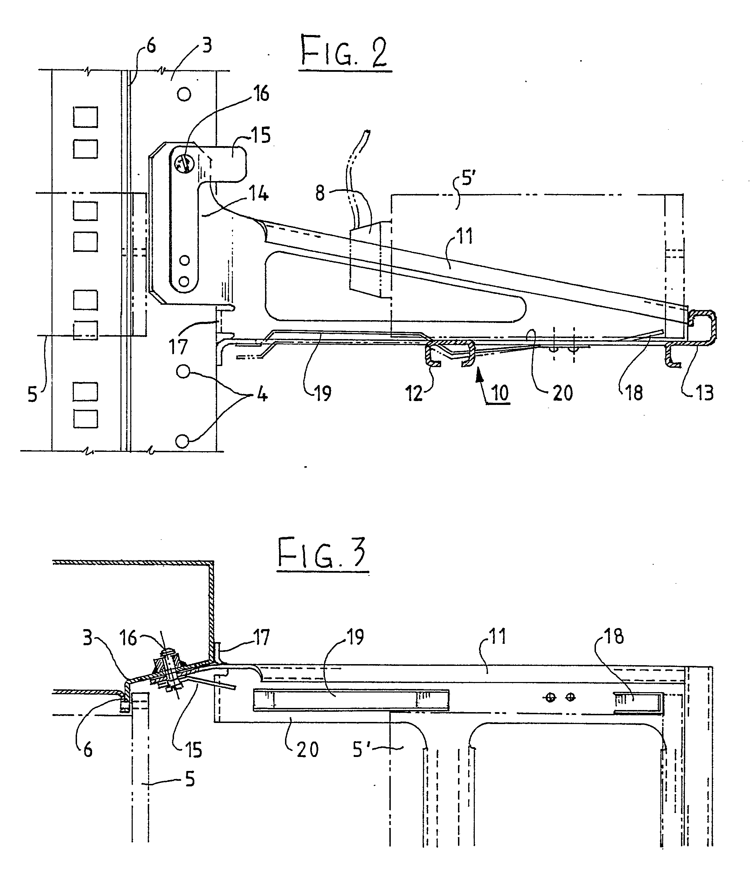

Der in Fig. 1 dargestellte Elektronikschrank 1 ist in üblicher Weise mit mehreren Fronteinschüben 5 ausgeführt, die übereinander durch die Frontöffnung 2 des Schrankes eingebaut und an ihrer Frontplatte mit dem Schrank verschraubt werden. In der Darstellung nach Fig. 1 ist ein Fronteinschub 5 bereits eingebaut, während ein weiterer, strichpunktiert gezeichneter Einschub 5' sich in "Wartestellung" auf einer Horizontalführung 10 befindet, die vor der Frontöffnung 2 lösbar angebracht ist. Die Horizontalführung 10 ist an den vertikalen Pfosten 3 des Schrankes, welche die seitliche Begrenzung der Frontöffnung 2 bilden, lösbar befestigt, und zwar so, dass die Frontöffnung für den Einschub frei bleibt. Nähere Einzelheiten gehen aus den Fig. 2 und 3 hervor.

Die symmetrisch ausgebildete Horizontalführung 10 besteht im wesentlichen aus zwei seitlichen Konsolen 11, die durch zwei Querstreben 12 und 13 miteinander fest verbunden sind. An den Konsolen 11 ist je ein Lappen 14 angeformt, welche Lappen an der Innenseite der Pfosten 3 zur Anlage kommen. Zur lösbaren Verbindung der Horizontalführung 10 mit dem Schrank 1 trägt jeder Lappen 14 eine Blattfeder 15, von welcher ein Bolzen 16 nach aussen durch eine Bohrung im Lappen hindurch absteht. Beim Ansetzen der schrankseitigen Lappen 14 lassen sich die Bolzen 16 in je eine von zwei gegenüberliegenden Bohrungen 4 einschnappen, welche an dem Pfosten 3 des Schrankes 1 vorgesehen sind. Wie ersichtlich, sind mehrere Bohrungen 4 übereinander angeordnet, und zwar vorzugsweise in einem Teilungsabstand, welcher auf die genormte Höhe der Einschübe 5 abgestimmt ist. Dadurch lässt sich die Horizontalführung 10 ausgerichtet auf die jeweilige Einbauhöhe eines Fronteinschubes 5 anbringen, wobei je ein unten an jeder Konsole 11 angebrachter, seitlich abstehender Lappen 17 sich an den beiden Seitenpfosten 3 abstützt. Um die Horizontalführung 10 vom Apparateschrank 1 zu lösen, werden die beiden Blattfedern 15 nach innen gebogen und dadurch die Bolzen ausser Eingriff mit den Bohrungen 4 gebracht.

Selbstverständlich sind auch andere Ausführungen von schrankseitigen Verbindungsorganen der Horizontalführung wie auch der am Schrank vorhandenen Mittel zur Höhenpositionierung denkbar, beispielsweise könnten die Konsolen 11 nach Art der bekannten Gestellkonsolen in vertikale Schlitze an den Seitenpfosten 3 eingehängt werden, oder es könnte eine Schraub- oder Klemmverbindung usw. vorgesehen werden.

Die Horizontalführung 10 bildet eine ebene Gleitfläche 20 zur Aufnahme eines Fronteinschubes 5'. Auf jeder Seite ragt ein ausgeklinkter Lappen 18 schräg über die Gleitfläche 20, und zwar in geeignetem Abstand zur Querstrebe 13, so dass die Frontplatte des Einschubes 5' zwischen Querstrebe 13 und Lappen 18 passt. Ein von der Horizontalführung 10 in ausgebauter Lage aufgenommener Fronteinschub 5' bleibt dadurch fixiert und kann sich nicht unbeabsichtigt auf der Gleitfläche 20 verschieben. In dieser Lage können am Fronteinschub 5' z.B. Steckverbindungen 8 hergestellt oder andere Manipulationen vorgenommen werden.

Durch Anheben des Fronteinschubes 5' an seiner Frontplatte kann der Einschub aus der Verankerung hinter den Lappen 18 gelöst und gegen die Einbaulage im Schrank 1 geschoben werden. Zur seitlichen Führung während des Einschiebens weist die Horizontalführung 10 auf beiden Seiten eine Seitenführung 19 auf. Diese Seitenführungen sind zweckmässigerweise in Form von streifenförmigen, gebogenen Blattfedern ausgebildet, die von unten durch einen Schlitz über die Gleitfläche 20 ragen. Im Verlaufe des Einbaus, wenn das Chassis des Einschubes 5' bereits teilweise in das Innere des Schrankes ragt, werden die Blattfedern 19 von der vorstehenden Frontplatte des Einschubes "überfahren" und nach unten gedrückt, in eine Lage, die in Fig. 2 strichpunktiert angedeutet ist. Der Fronteinschub 5' wird dann von Führungsleisten 7 (Fig. 1) übernommen, die innen an den Seitenwänden des Schrankes 1 fest angebracht sind. Der Einbau ist beendet, wenn die Frontplatte des Einschubes an einspringenden Flanschen 6 der Seitenpfosten 3 zur Anlage kommt und mit diesen verschraubt wird. Die Horizontalführung 10 kann dann vom Apparateschrank 1 abgenommen werden.

Mit der beschriebenen Hilfsvorrichtung in Form der Horizontalführung 10 können der Ein- und Ausbau von Fronteinschüben wie auch Wartungsarbeiten usw. in ausgebauter Lage mühelos und ohne Beschädigungsgefahr von einer Person vorgenommen werden, selbst unter erschwerten Bedingungen, z.B. bei mobilen Anlagen.

**Ansprüche**

1. Führungsanordnung für Fronteinschübe von Apparate-, insbesondere Elektronikschränken, gekennzeichnet durch eine vor der Frontöffnung (2) des Schrankes (1) lösbar anbringbare Horizontalführung (10), die auf die Einbauhöhe eines Fronteinschubes (5) ausgerichtet und zu dessen vorübergehenden Aufnahme ausserhalb des Schrankes (1) ausgebildet ist.

2. Führungsanordnung nach Anspruch 1, dadurch gekennzeichnet, dass die Horizontalführung (10) mit schrankseitigen Verbindungsorganen (14 - 16) versehen ist, die zum Zusammenwirken mit an den seitlichen Begrenzungen (3) der Frontöffnung (2) vorhandenen Höhenpositioniermitteln (4) bestimmt sind.

3. Führungsanordnung nach Anspruch 1 oder 2, dadurch gekennzeichnet, dass die Horizontalführung (10) Fixiermittel (13, 18) zum Positionieren eines Fronteinschubes (5) in einer ausgebauten Lage aufweist.

4. Führungsanordnung nach einem der vorangehenden Ansprüche, dadurch gekennzeichnet, dass die Horizontalführung (10) über einer Einschub-Gleitfläche (20) angeordnete Seitenführungen (19) für die Fronteinschübe (5) aufweist.

5. Führungsanordnung nach Anspruch 4, dadurch gekennzeichnet, dass die Seitenführungen (19) unter die Einschub-Gleitfläche (2) absenkbar ausgebildet sind.

# FIG.1

FIG. 2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4 ) |
|---|---|---|---|
| X | US-A-2572617 (P.T.HAURY ET AL) <br> * Spalte 3, Zeile 9 - Zeile 75; Anspruch 1; Figuren 1, 2, 4 * <br> --- | 1 | H05K7/14 |
| X | US-A-4258965 (M.STONER) <br> * das ganze Dokument * <br> --- | 1 | |
| A | DE-B-1057671 (SIEMENS & HALSKE) <br> * Spalte 1, Zeile 1 - Zeile 6 * <br> * Spalte 3, Zeile 15 - Zeile 63; Figur 1 * <br> --- | 1,3,4 | |
| A | GB-A-805175 (COMMISSARIAT A L'ENERGIE ATOMIQUE) <br> * Seite 1, Zeile 38 - Zeile 49 * <br> * Seite 2, Zeile 105 - Zeile 128; Figur 2 * <br> ----- | 1,4,5 | |

**RECHERCHIERTE SACHGEBIETE (Int. Cl.4 )**

H05K
H02B

Der vorliegende Recherchenbericht wurde für alle Patentansprüche erstellt

| Recherchenort | Abschlußdatum der Recherche | Prüfer |
|---|---|---|
| DEN HAAG | 24 JANUAR 1989 | WOODALL C.G. |